# EUROPEAN PATENT SPECIFICATION

(11) **EP 3 255 969 B1**
(45) Date of publication and mention of the grant of the patent: **31.07.2024**
(21) Application number: 16816924.1
(22) Date of filing: 05.02.2016
(51) Int. Cl.: H01L 23/373

(54) **HEAT-CONDUCTING SHEET AND ELECTRONIC DEVICE**
WÄRMELEITFOLIE UND ELEKTRONISCHE VORRICHTUNG
FEUILLE CONDUCTRICE DE CHALEUR ET DISPOSITIF ÉLECTRONIQUE

(30) Priority: 29.06.2015 CN 201510368581
(43) Date of publication of application: 13.12.2017
(73) Proprietor: Huawei Technologies Co., Ltd., Longgang District Shenzhen, Guangdong 518129 (CN)
(72) Inventor: XU, Yan, Shenzhen, Guangdong 518129 (CN); ZHAO, Renzhe, Shenzhen, Guangdong 518129 (CN)
(74) Representative: Maiwald GmbH
(86) International application number: PCT/CN2016/073612
(87) International publication number: WO 2017/000559

(56) References cited:
- EP-A1- 2 343 332
- WO-A1-2012/040148
- WO-A1-2014/044557
- WO-A1-2014/176185
- CN-A- 101 760 035
- CN-A- 102 384 697
- CN-A- 103 228 120
- CN-A- 104 918 468
- CN-U- 204 047 017
- CN-Y- 200 997 743
- JP-A- 2005 159 318
- US-A1- 2013 112 389
- US-A1- 2013 265 721
- US-A1- 2014 069 622
- US-A1- 2014 218 867

## Description

### TECHNICAL FIELD

Embodiments of the present invention relate to the field of electronic device technologies, and in particular, to a thermal pad and an electronic device.

### BACKGROUND

Heat generated when a chip in an electronic device works generally needs to be dissipated to the outside by using a heat sink. From a microscopic perspective, contact interfaces of the chip and the heat sink are both rough, and a thermal pad needs to be made out of a thermal interface material to fill between the contact interfaces of the chip and the heat sink, to reduce contact thermal resistance. The thermal interface material generally includes thermally conductive silicone, a thermally conductive pad, thermal gel, a phase-change thermally conductive material, a thermally conductive double-sided tape, and the like. Thermal interface materials of different types with different coefficients of thermal conductivity may be used according to different application scenarios.

As a power density of a chip in an electronic device continuously increases, for heat dissipation of a high-power chip, because a problem of a partial hotspot occurs during packaging of the chip, and an existing thermal pad has a high coefficient of thermal conductivity only in a thickness direction, heat of the partial hotspot cannot be dissipated in time, and a service life of the chip is affected.

CN 200 997 743 Y discloses a kind of heat conduction heat dissipating double-fuselage that comprises a bond line of a silicone and a graphite heat conduction thermal layer.

CN 204 047 017 U discloses a heat conductive pad for a heat transmission between electronic equipment and a product casing. The conductive pad comprises a laminated structure of a heat conducting base material of graphite and two layers of elastic conducting thermosphere made of a silica gel, a silicone grease or a thermal conductive silicon cream. The conductive coefficient of the base material is greater than the conductive coefficient of the elastic conducting thermosphere.

US 2013/112389 discloses a thermal pad with multiple layers designed to enhance heat dissipation from heat-generating components in electronic devices.

### SUMMARY

Embodiments of the present invention provide a thermal pad, according to claims 1-8 and an electronic device, according to claim 9, to effectively relieve a heat dissipation difficulty caused by a problem of a partial hotspot of a heat emitting component.

### BRIEF DESCRIPTION OF DRAWINGS

To describe the technical solutions in the embodiments of the present invention or in the prior art more clearly, the following briefly introduces the accompanying drawings required for describing the embodiments or the prior art. Apparently, the accompanying drawings in the following description show some embodiments of the present invention, and a person of ordinary skill in the art may still derive other drawings from these accompanying drawings without creative efforts.
FIG. 1 is a schematic structural diagram of Embodiment 1 of a thermal pad according to the present invention;
FIG. 2 is a schematic structural diagram of Embodiment 2 of a thermal pad according to the present invention;
FIG. 3 is a schematic structural diagram of Embodiment 1 of a first heat conducting layer in a thermal pad according to the present invention;
FIG. 4 is a schematic structural diagram of Embodiment 3 of a thermal pad according to the present invention;
FIG. 5 is a schematic structural diagram of Embodiment 1 of an electronic device according to the present invention;
FIG. 6 is a flowchart of Embodiment 1 of a method for manufacturing a thermal pad not forming part of the present invention; and
FIG. 7 is a flowchart of Embodiment 2 of a method for manufacturing a thermal pad not forming part of the present invention.

### DESCRIPTION OF EMBODIMENTS

To make the objectives, technical solutions, and advantages of the embodiments of the present invention clearer, the following clearly and completely describes the technical solutions in the embodiments of the present invention with reference to the accompanying drawings in the embodiments of the present invention. Apparently, the described embodiments are some but not all of the embodiments of the present invention. All other embodiments obtained by a person of ordinary skill in the art based on the embodiments of the present invention without creative efforts shall fall within the protection scope of the present invention.

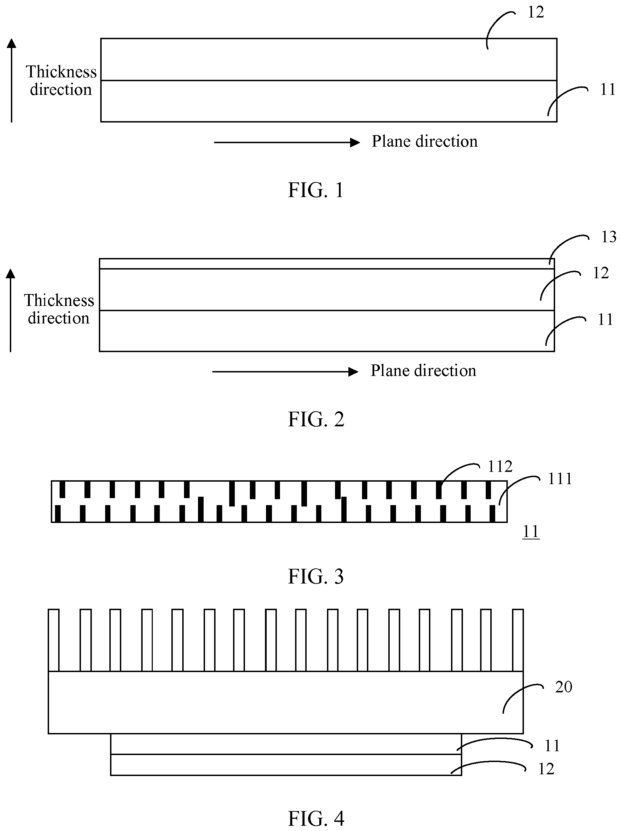

FIG. 1 is a schematic structural diagram of Embodiment 1 of a thermal pad according to the present invention. As shown in FIG. 1, the thermal pad in this embodiment is configured to perform heat dissipation for a heat emitting component, and includes a first heat conducting layer 11 and a second heat conducting layer 12. A first surface of the second heat conducting layer 12 is in contact with a surface of the heat emitting component, and a second surface of the second heat conducting layer 12 is in contact with a first surface of the first heat conducting layer 11. The first heat conducting layer 11 is a heat conducting layer that can be compressed to deform, and a heat conduction capability of the first heat conducting layer 11 in a thickness direction of the first heat conducting layer 11 is higher than a heat conduction capability of the first heat conducting layer 11 in a plane direction of the first heat conducting layer 11. It should be noted that the thickness direction of the first heat conducting layer is perpendicular to the plane direction of the first heat conducting layer. Because the heat conduction capability of the first heat conducting layer in the thickness direction of the first heat conducting layer 11 is higher than the heat conduction capability of the first heat conducting layer 11 in the plane direction of the first heat conducting layer 11, the thermal pad in this embodiment has a high heat conduction capability in a thickness direction of the thermal pad. In addition, the second heat conducting layer 12 in this embodiment is a heat conducting layer that cannot be compressed to deform, a heat conduction capability of the second heat conducting layer 12 in a plane direction of the second heat conducting layer 12 is higher than or equal to a heat conduction capability of the second heat conducting layer 12 in a thickness direction of the second heat conducting layer 12, and the heat conduction capability of the second heat conducting layer 12 in the plane direction of the second heat conducting layer 12 is higher than or equal to the heat conduction capability of the first heat conducting layer 11 in the thickness direction of the first heat conducting layer 11. It should be noted that the thickness direction of the second heat conducting layer 12 is perpendicular to the plane direction of the second heat conducting layer 12. Therefore, the thermal pad in this embodiment has a higher heat conduction capability in a plane direction of the thermal pad. To sum up, the thermal pad in this embodiment not only has a high heat conduction capability in the thickness direction, but also has a higher heat conduction capability in the plane direction.

That the first heat conducting layer is a heat conducting layer that can be compressed to deform specifically refers to: a ratio of compression and deformation of the first heat conducting layer under the action of first pressure is 5% to 90%, where the first pressure ranges between 0 N and 5000 N. Preferably, the first pressure ranges between 0 N to 200 N.

That the second heat conducting layer is a heat conducting layer that cannot be compressed to deform specifically refers to: a ratio of compression and deformation of the second heat conducting layer under the action of the first pressure is 0% to 5%.

Optionally, a thickness of the first heat conducting layer is 0.2 mm to 5 mm, and a thickness of the second heat conducting layer is 0.1 mm to 5 mm.

The thermal pad in this embodiment includes a second heat conducting layer that is in contact with a surface of a heat emitting component, and a first heat conducting layer that is in contact with a surface of the second heat conducting layer. Because a heat conduction capability of the second heat conducting layer in a plane direction of the second heat conducting layer is higher than or equal to a heat conduction capability of the second heat conducting layer in a thickness direction of the second heat conducting layer, after the second heat conducting layer receives heat transferred by the heat emitting component, for the heat, a dissipation capability in the plane direction of the second heat conducting layer is higher than a conduction capability in the thickness direction of the second heat conducting layer, and because the heat conduction capability of the second heat conducting layer in the plane direction of the second heat conducting layer is higher than a heat conduction capability of the first heat conducting layer in a thickness direction of the first heat conducting layer, the second heat conducting layer can fully dissipate the heat in the plane direction of the second heat conducting layer, and then conduct the heat to the first heat conducting layer, thereby avoiding that when the heat emitting component partially emits excessive heat and causes an excessively high temperature, a partial hotspot appears on the second heat conducting layer that is in contact with the heat emitting component, and a device is damaged because heat of the partial hotspot cannot be conducted out in time. Then, because the heat conduction capability of the first heat conducting layer in the thickness direction of the first heat conducting layer is higher than a heat conduction capability of the first heat conducting layer in a plane direction of the first heat conducting layer, the first heat conducting layer can conduct the heat out in time. When heat dissipation processing is performed on a heat emitting component by using the thermal pad provided in this embodiment of the present invention, a phenomenon that a device is damaged because the heat emitting component partially emits excessive heat and forms a partial hotspot, and the heat of the partial hotspot cannot be conducted out in time can be avoided.

FIG. 2 is a schematic structural diagram of Embodiment 2 of a thermal pad according to the present invention. As shown in FIG. 2, based on Embodiment 1 of the present invention, the thermal pad in this embodiment further includes: a third heat conducting layer 13, where the third heat conducting layer 13 is disposed between the heat emitting component and the second heat conducting layer 12, a first surface of the third heat conducting layer 13 is in contact with the surface of the heat emitting component, a second surface of the third heat conducting layer 13 is in contact with the first surface of the second heat conducting layer 12, the third heat conducting layer 13 is configured to fill in a micro void on the surface of the heat emitting component, and a thickness of the third heat conducting layer 13 is greater than 0 and is less than the thickness of the first heat conducting layer 11. Therefore, when the thermal pad in this embodiment is disposed between the heat emitting component and a heat sink, the third heat conducting layer 13 is in contact with the heat emitting component, and the third heat conducting layer 13 can reduce contact thermal resistance between the second heat conducting layer 12 and the heat emitting component, which further improves a heat dissipation effect.

Based on Embodiment 2 of the present invention, optionally, the thickness of the third heat conducting layer 13 is less than or equal to 0.2 mm. The third heat conducting layer is made relatively thin, so as to reduce the contact thermal resistance. In addition, the third heat conducting layer 13 is a prepreg or the third heat conducting layer 13 is gel-like.

Based on Embodiment 1 or 2 in the present invention, as shown in FIG. 3, the first heat conducting layer 11 includes an organic matrix 111 and a heat conducting filler 112, and the heat conducting filler 112 is orientated in the first heat conducting layer 11 in the thickness direction of the first heat conducting layer 11. Because the heat conducting filler 112 is orientated in the first heat conducting layer 11 in the thickness direction of the first heat conducting layer 11, the heat conduction capability of the first heat conducting layer 11 in the thickness direction of the first heat conducting layer 11 is higher than the heat conduction capability of the first heat conducting layer 11 in the plane direction of the first heat conducting layer 11. Optionally, the organic matrix may include ethylene-containing organopolysiloxane and hydride terminated polydimethylsiloxane-containing organopolysiloxane. The heat conducting filler includes a sheet-like heat conducting filler, or the heat conducting filler includes a fiber-like heat conducting filler, or the heat conducting filler includes a sheet-like heat conducting filler and a fiber-like heat conducting filler. For example, the heat conducting filler may include spherical alumina particles (having a particle size of 2 µm to 50 µm) and pitch-based carbon fibers (having an axial length of 60 µm to 180 µm and an axial diameter of 5 µm to 15 µm), or the heat conducting filler may include spherical alumina particles (having a particle size of 2 µm to 50 µm) and sheet-like boron nitride (having a particle size of 5 µm to 15 µm).

Optionally, the heat conducting filler is a heat conducting fiber, and the heat conducting fiber may be a carbon fiber or a carbon nanotube.

Optionally, a material of the second heat conducting layer 12 includes a material that has high thermal conductivity in a plane direction, such as metal, or graphite, or metal and graphite, or a graphene film, or a carbon nanotube film. Optionally, the metal may be copper. A coefficient of thermal conductivity of the second heat conducting layer 12 in the plane direction in this embodiment is hundreds of W/mk, and even thousands of W/mk, which can effectively reduce plane extension thermal resistance.

FIG. 4 is a schematic structural diagram of Embodiment 3 of a thermal pad according to the present invention. As shown in FIG. 4, based on the foregoing thermal pad embodiments in the present invention, in the thermal pad in this embodiment, further, the second surface of the first heat conducting layer 11 of the thermal pad is in contact with a heat sink 20.

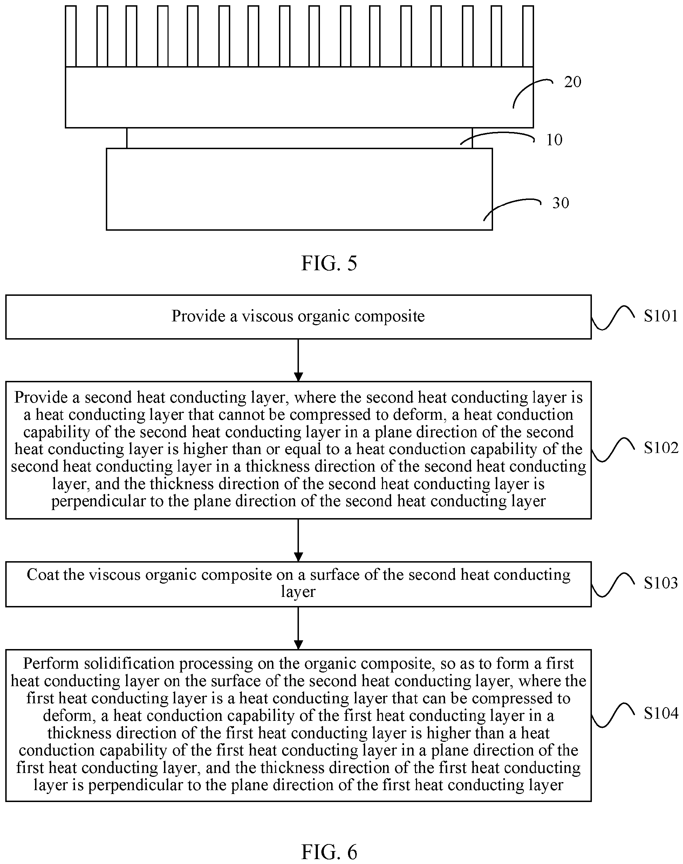

FIG. 5 is a schematic structural diagram of Embodiment 1 of an electronic device according to the present invention. As shown in FIG. 5, a heat dissipation apparatus in this embodiment may include a thermal pad 10 and a heat emitting component 30, where the thermal pad 10 is the thermal pad provided in the foregoing thermal pad embodiments in the present invention, and the implementation principles and technical effects thereof are similar, and are not described herein again. It should be noted that, in this embodiment, a surface of the thermal pad 10 is in contact with a surface of the heat emitting component 30, and the thermal pad 10 performs heat dissipation processing on heat generated by the heat emitting component 30. If the thermal pad 10 is further in contact with a heat sink 20, a surface of a first heat conducting layer of the thermal pad 10 is in contact with the heat sink 20.

FIG. 6 is a flowchart of Embodiment 1 of a method for manufacturing a thermal pad not forming part of the present invention. As shown in FIG. 6, the method in this embodiment may include:
S101: Provide a viscous organic composite.
S102: Provide a second heat conducting layer, where the second heat conducting layer is a heat conducting layer that cannot be compressed to deform, a heat conduction capability of the second heat conducting layer in a plane direction of the second heat conducting layer is higher than or equal to a heat conduction capability of the second heat conducting layer in a thickness direction of the second heat conducting layer, and the thickness direction of the second heat conducting layer is perpendicular to the plane direction of the second heat conducting layer.

For example, the second heat conducting layer is a graphite sheet whose thickness is 0.9 mm, 0.5 mm, or 1 mm.

S103: Coat the viscous organic composite on a surface of the second heat conducting layer.

S104: Perform solidification processing on the organic composite, so as to form a first heat conducting layer on the surface of the second heat conducting layer, where the first heat conducting layer is a heat conducting layer that can be compressed to deform, a heat conduction capability of the first heat conducting layer in a thickness direction of the first heat conducting layer is higher than a heat conduction capability of the first heat conducting layer in a plane direction of the first heat conducting layer, and the thickness direction of the first heat conducting layer is perpendicular to the plane direction of the first heat conducting layer.

In an implementation manner of this embodiment, a viscous organic composite is provided, where the organic composite may include a heat conducting filler. For example, ethylene-containing organopolysiloxane, hydride terminated polydimethylsiloxane-containing organopolysiloxane, spherical alumina particles (having a particle size of 2 µm to 50 µm), and pitch-based carbon fibers (having an axial length of 60 µm to 180 µm and an axial diameter of 5 µm to 15 µm) are mixed evenly according to a particular proportion (18:18:34:30) (of percents in volume), and are stirred to disperse into the viscous organic composite; or ethylene-containing organopolysiloxane, hydride terminated polydimethylsiloxane-containing organopolysiloxane, spherical alumina particles (having a particle size of 2 µm to 50 µm), and sheet-like boron nitride (having a particle size of 5 µm to 15 µm) are mixed evenly according to a particular proportion (50:50:80:150) (of percents in weight), and are stirred to disperse into the viscous organic composite; or ethylene-containing organopolysiloxane, hydride terminated polydimethylsiloxane-containing organopolysiloxane, spherical alumina particles (having a particle size of 2 µm to 50 µm), sheet-like boron nitride (having a particle size of 5 µm to 15 µm), and nanographene sheets (a thickness is 0.4 nm to 4 nm and a length is 5 µm to 20 µm) are mixed evenly according to a particular proportion (50:50:80:60:1.5) (of percents in weight), and are stirred to disperse into the viscous organic composite.

Then, the viscous organic composite provided in S101 is coated on a surface of a second heat conducting layer provided in S102. Then, the heat conducting filler in the organic composite is orientated, and the organic composite is solidified. The organic composite forms a first heat conducting layer after the orientation processing and the solidification processing. Therefore, the first heat conducting layer is formed on the second heat conducting layer. In addition, the heat conducting filler after the orientation processing is orientated in a thickness direction of the first heat conducting layer. In this way, a heat conduction capability of the formed first heat conducting layer in the thickness direction of the first heat conducting layer is higher than a heat conduction capability of the first heat conducting layer in a plane direction of the first heat conducting layer. The orientation processing may be magnetic field orientation processing, electric field orientation processing, or stress orientation processing.

For example, the second heat conducting layer may be first placed in an orientation mold, the viscous organic composite is then poured on a surface of the second heat conducting layer in the orientation mold, and a magnetic field or an electric field is applied to the orientation mold, so as to implement magnetic field orientation processing or electric field orientation processing on the heat conducting filler in the organic composite, or stress is applied so as to implement stress orientation processing on the heat conducting filler in the organic composite, so that the heat conducting filler is orientated in a direction perpendicular to the plane direction of the second heat conducting layer; and the organic composite is heated and solidified in a heating furnace at 100°C to 120°C for four hours to six hours to form a shape, so as to form the first heat conducting layer.

In this embodiment, in the thermal pad obtained in the foregoing manner, because a heat conduction capability of a second heat conducting layer in a plane direction of the second heat conducting layer is higher than or equal to a heat conduction capability of the second heat conducting layer in a thickness direction of the second heat conducting layer, after the second heat conducting layer receives heat transferred by a heat emitting component, for the heat, a dissipation capability in the plane direction of the second heat conducting layer is higher than a conduction capability in the thickness direction of the second heat conducting layer, and because the heat conduction capability of the second heat conducting layer in the plane direction of the second heat conducting layer is higher than a heat conduction capability of a first heat conducting layer in a thickness direction of the first heat conducting layer, the second heat conducting layer can fully dissipate the heat in the plane direction of the second heat conducting layer, and then conduct the heat to the first heat conducting layer, thereby avoiding that when the heat emitting component partially emits excessive heat and causes an excessively high temperature, a partial hotspot appears on the second heat conducting layer that is in contact with the heat emitting component, and a device is damaged because heat of the partial hotspot cannot be conducted out in time. Then, because the heat conduction capability of the first heat conducting layer in the thickness direction of the first heat conducting layer is higher than a heat conduction capability of the first heat conducting layer in a plane direction of the first heat conducting layer, the first heat conducting layer can conduct the heat out in time. When heat dissipation processing is performed on a heat emitting component by using the thermal pad provided in this embodiment of the present invention, a phenomenon that a device is damaged because the heat emitting component partially emits excessive heat and forms a partial hotspot, and the heat of the partial hotspot cannot be conducted out in time can be avoided.

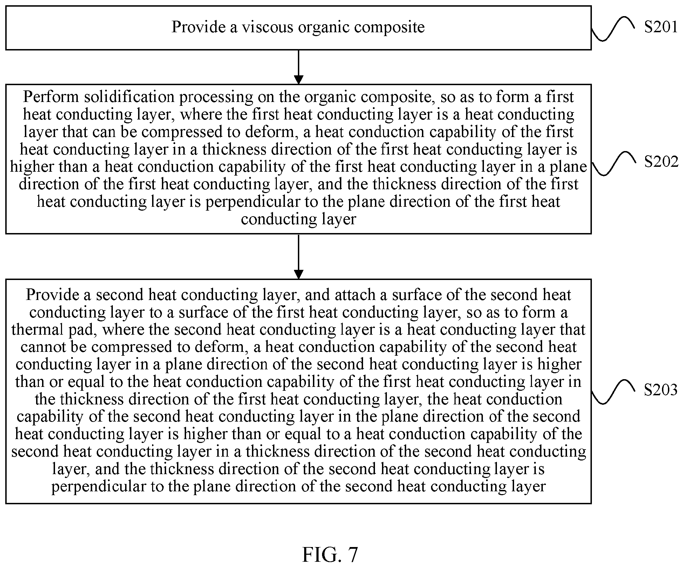

FIG. 7 is a flowchart of Embodiment 2 of a method for manufacturing a thermal pad not forming part of the present invention. As shown in FIG. 7, the method in this embodiment may include:
S201: Provide a viscous organic composite.
S202: Perform solidification processing on the organic composite, so as to form a first heat conducting layer, where the first heat conducting layer is a heat conducting layer that can be compressed to deform, a heat conduction capability of the first heat conducting layer in a thickness direction of the first heat conducting layer is higher than a heat conduction capability of the first heat conducting layer in a plane direction of the first heat conducting layer, and the thickness direction of the first heat conducting layer is perpendicular to the plane direction of the first heat conducting layer.
S203: Provide a second heat conducting layer, and attach a surface of the second heat conducting layer to a surface of the first heat conducting layer, so as to form the thermal pad, where the second heat conducting layer is a heat conducting layer that cannot be compressed to deform, a heat conduction capability of the second heat conducting layer in a plane direction of the second heat conducting layer is higher than or equal to the heat conduction capability of the first heat conducting layer in the thickness direction of the first heat conducting layer, the heat conduction capability of the second heat conducting layer in the plane direction of the second heat conducting layer is higher than or equal to a heat conduction capability of the second heat conducting layer in a thickness direction of the second heat conducting layer, the thickness direction of the second heat conducting layer is perpendicular to the plane direction of the second heat conducting layer.

In an implementation manner of this embodiment, a viscous organic composite is provided, where the organic composite may include a heat conducting filler. For example, ethylene-containing organopolysiloxane, hydride terminated polydimethylsiloxane-containing organopolysiloxane, spherical alumina particles (having a particle size of 2 µm to 50 µm), and pitch-based carbon fibers (having an axial length of 60 µm to 180 µm and an axial diameter of 5 µm to 15 µm) are mixed evenly according to a particular proportion (18:18:34:30) (of percents in volume), and are stirred to disperse into the viscous organic composite; or ethylene-containing organopolysiloxane, hydride terminated polydimethylsiloxane-containing organopolysiloxane, spherical alumina particles (having a particle size of 2 µm to 50 µm), and sheet-like boron nitride (having a particle size of 5 µm to 15 µm) are mixed evenly according to a particular proportion (50:50:80:150) (of percents in weight), and are stirred to disperse into the viscous organic composite; or ethylene-containing organopolysiloxane, hydride terminated polydimethylsiloxane-containing organopolysiloxane, spherical alumina particles (having a particle size of 2 µm to 50 µm), sheet-like boron nitride (having a particle size of 5 µm to 15 µm), and nanographene sheets (a thickness is 0.4 nm to 4 nm and a length is 5 µm to 20 µm) are mixed evenly according to a particular proportion (50:50:80:60:1.5) (of percents in weight), and are stirred to disperse into the viscous organic composite.

Then, the organic composite is solidified, so as to form a first heat conducting layer, and the heat conducting filler is orientated in a thickness direction of the first heat conducting layer. In this way, a heat conduction capability of the formed first heat conducting layer in the thickness direction of the first heat conducting layer is higher than a heat conduction capability of the first heat conducting layer in a plane direction of the first heat conducting layer. The orientation processing may be magnetic field orientation processing, electric field orientation processing, or stress orientation processing.

For example, the viscous organic composite is poured into an orientation mold, and a magnetic field or an electric field is applied to the orientation mold, so as to implement magnetic field orientation processing or electric field orientation processing on the heat conducting filler in the organic composite, or stress is applied so as to implement stress orientation processing on the heat conducting filler in the organic composite, so that the heat conducting filler is orientated in a direction perpendicular to the thickness direction of the first heat conducting layer; and the organic composite is heated and solidified in a heating furnace at 100°C to 120°C for four hours to six hours to form a shape, so as to form the first heat conducting layer.

For example, the second heat conducting layer is a graphite sheet whose thickness is 0.9 mm, 0.5 mm, or 1 mm. After S202, a surface of the second heat conducting layer is attached to a surface of the first heat conducting layer on which orientation processing and solidification processing are performed, so as to form the thermal pad.

For example, a surface of the second heat conducting layer may be coated with a heat conducting pressure-sensitive adhesive layer whose thickness is 10 µm, a separation film is added, and a surface of the first heat conducting layer is recombined with the second heat conducting layer whose surface has a heat conduction pressure-sensitive adhesive layer, so that the second heat conducting layer is attached to the first heat conducting layer, to form the thermal pad.

In this embodiment, in the thermal pad obtained in the foregoing manner, because a heat conduction capability of a second heat conducting layer in a plane direction of the second heat conducting layer is higher than or equal to a heat conduction capability of the second heat conducting layer in a thickness direction of the second heat conducting layer, after the second heat conducting layer receives heat transferred by a heat emitting component, for the heat, a dissipation capability in the plane direction of the second heat conducting layer is higher than a conduction capability in the thickness direction of the second heat conducting layer, and because the heat conduction capability of the second heat conducting layer in the plane direction of the second heat conducting layer is higher than a heat conduction capability of a first heat conducting layer in a thickness direction of the first heat conducting layer, the second heat conducting layer can fully dissipate the heat in the plane direction of the second heat conducting layer, and then conduct the heat to the first heat conducting layer, thereby avoiding that when the heat emitting component partially emits excessive heat and causes an excessively high temperature, a partial hotspot appears on the second heat conducting layer that is in contact with the heat emitting component, and a device is damaged because heat of the partial hotspot cannot be conducted out in time. Then, because the heat conduction capability of the first heat conducting layer in the thickness direction of the first heat conducting layer is higher than a heat conduction capability of the first heat conducting layer in a plane direction of the first heat conducting layer, the first heat conducting layer can conduct the heat out in time. When heat dissipation processing is performed on a heat emitting component by using the thermal pad provided in this embodiment of the present invention, a phenomenon that a device is damaged because the heat emitting component partially emits excessive heat and forms a partial hotspot, and the heat of the partial hotspot cannot be conducted out in time can be avoided.

Optionally, based on Method Embodiment 1 or 2 in the present invention, the method further includes: forming a third heat conducting layer on the other surface opposite the surface, which is combined with the first heat conducting layer, of the second heat conducting layer, where the third heat conducting layer is configured to fill in a micro void on the surface of the heat emitting component. For example, a layer of thermally conductive silicone whose thickness is 0.05 mm to 0.15 mm is applied to the surface of the second heat conducting layer by using a printing process. The thermal pad obtained by using the method in this embodiment further includes the foregoing third heat conducting layer, which can reduce contact thermal resistance of the thermal pad.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of the embodiments of the present invention.

## Claims

1. A thermal pad, configured to perform heat dissipation for a heat emitting component (30), wherein
the thermal pad comprises a first heat conducting layer (11) and a second heat conducting layer (12), a second surface of the second heat conducting layer (12) is in contact with a first surface of the first heat conducting layer (11);
the first heat conducting layer (11) is a heat conducting layer that can be compressed to deform, a heat conduction capability of the first heat conducting layer (11) in a thickness direction of the first heat conducting layer (11) is higher than a heat conduction capability of the first heat conducting layer (11) in a plane direction of the first heat conducting layer (11), and the thickness direction of the first heat conducting layer (11) is perpendicular to the plane direction of the first heat conducting layer (11); and
the second heat conducting layer (12) is a heat conducting layer that cannot be compressed to deform, a heat conduction capability of the second heat conducting layer (12) in a plane direction of the second heat conducting layer (12) is higher than a heat conduction capability of the second heat conducting layer (12) in a thickness direction of the second heat conducting layer (12), the heat conduction capability of the second heat conducting layer (12) in the plane direction of the second heat conducting layer (12) is higher than or equal to the heat conduction capability of the first heat conducting layer (11) in the thickness direction of the first heat conducting layer (11), and the thickness direction of the second heat conducting layer (12) is perpendicular to the plane direction of the second heat conducting layer (12);
wherein the first heat conducting layer comprises an organic matrix and a heat conducting filler, and the heat conducting filler is orientated in the first heat conducting layer in the thickness direction of the first heat conducting layer;
wherein the thermal pad further comprises a third heat conducting layer, wherein the third heat conducting layer is disposed between the heat emitting component (30) and the second heat conducting layer (12), a first surface of the third heat conducting layer is in contact with the surface of the heat emitting component (30), a second surface of the third heat conducting layer is in contact with a first surface of the second heat conducting layer (12), and the third heat conducting layer is configured to fill in a micro void on the surface of the heat emitting component (30).

2. The thermal pad according to claim 1, wherein that the first heat conducting layer (11) is a heat conducting layer that can be compressed to deform specifically refers to:
a ratio of compression and deformation of the first heat conducting layer (11) under the action of first pressure is 5% to 90%, wherein the first pressure ranges between 0 N and 5000 N.

3. The thermal pad according to claim 2, wherein that the second heat conducting layer (12) is a heat conducting layer that cannot be compressed to deform specifically refers to:
a ratio of compression and deformation of the second heat conducting layer (12) under the action of the first pressure is less than or equal to 5%.

4. The thermal pad according to any one of claims 1 to 3, wherein
a thickness of the first heat conducting layer (11) is 0.2 mm to 5 mm, and a thickness of the second heat conducting layer (12) is 0.1 mm to 5 mm.

5. The thermal pad according to any of the claims 1 to 4, wherein a thickness of the third heat conducting layer is less than or equal to 0.2 mm, and the third heat conducting layer is a prepreg or the third heat conducting layer is gel-like.

6. The thermal pad according to claim 1, wherein
the heat conducting filler (112) comprises a sheet-like heat conducting filler; or
the heat conducting filler (112) comprises a fiber-like heat conducting filler; or
the heat conducting filler (112) comprises a sheet-like heat conducting filler and a fiber-like heat conducting filler.

7. The thermal pad according to any one of claims 1 to 6, wherein a material of the second heat conducting layer (12) comprises at least one of: metal or graphite.

8. The thermal pad according to any one of claims 1 to 7, wherein a second surface of the first heat conducting layer (11) is in contact with a heat sink (20).

9. An electronic device, comprising: the thermal pad according to any one of claims 1 to 8 and a heat emitting component (30), wherein a surface of the thermal pad is in contact with a surface of the heat emitting component (30); and
the thermal pad is configured to perform heat dissipation processing on heat generated by the heat emitting component (30).

## Patentansprüche

1. Wärmeleitpad, das konfiguriert ist, um eine Wärmeableitung für eine wärmeemittierende Komponente (30) durchzuführen, wobei
das Wärmeleitpad eine erste wärmeleitende Schicht (11) und eine zweite wärmeleitende Schicht (12) umfasst, eine zweite Oberfläche der zweiten wärmeleitenden Schicht (12) mit einer ersten Oberfläche der ersten wärmeleitenden Schicht (11) in Kontakt steht;
die erste wärmeleitende Schicht (11) eine wärmeleitende Schicht ist, die komprimiert werden kann, um sich zu verformen, eine Wärmeleitfähigkeit der ersten wärmeleitenden Schicht (11) in einer Dickenrichtung der ersten wärmeleitenden Schicht (11) höher als eine Wärmeleitfähigkeit der ersten wärmeleitenden Schicht (11) in einer Ebenenrichtung der ersten wärmeleitenden Schicht (11) ist, und die Dickenrichtung der ersten wärmeleitenden Schicht (11) zu der Ebenenrichtung der ersten wärmeleitenden Schicht (11) senkrecht ist; und
die zweite wärmeleitende Schicht (12) eine wärmeleitende Schicht ist, die nicht komprimiert werden kann, um sich zu verformen, eine Wärmeleitfähigkeit der zweiten wärmeleitenden Schicht (12) in einer Ebenenrichtung der zweiten wärmeleitenden Schicht (12) höher als eine Wärmeleitfähigkeit der zweiten wärmeleitenden Schicht (12) in einer Dickenrichtung der zweiten wärmeleitenden Schicht (12) ist, die Wärmeleitfähigkeit der zweiten wärmeleitenden Schicht (12) in der Ebenenrichtung der zweiten wärmeleitenden Schicht (12) höher als oder gleich der Wärmeleitfähigkeit der ersten wärmeleitenden Schicht (11) in der Dickenrichtung der ersten wärmeleitenden Schicht (11) ist, und die Dickenrichtung der zweiten wärmeleitenden Schicht (12) zu der Ebenenrichtung der zweiten wärmeleitenden Schicht (12) senkrecht ist;
wobei die erste wärmeleitende Schicht eine organische Matrix und einen wärmeleitenden Füllstoff umfasst und der wärmeleitende Füllstoff in der ersten wärmeleitenden Schicht in der Dickenrichtung der ersten wärmeleitenden Schicht ausgerichtet ist;
wobei das Wärmeleitpad ferner eine dritte wärmeleitende Schicht umfasst, wobei die dritte wärmeleitende Schicht zwischen der wärmeemittierenden Komponente (30) und der zweiten wärmeleitenden Schicht (12) angeordnet ist, eine erste Oberfläche der dritten wärmeleitenden Schicht mit der Oberfläche der wärmeemittierenden Komponente (30) in Kontakt steht, eine zweite Oberfläche der dritten wärmeleitenden Schicht mit einer ersten Oberfläche der zweiten wärmeleitenden Schicht (12) in Kontakt steht und die dritte wärmeleitende Schicht konfiguriert ist, um einen Mikrohohlraum auf der Oberfläche der wärmeemittierenden Komponente (30) aufzufüllen.

2. Wärmeleitpad nach Anspruch 1, wobei, dass die erste wärmeleitende Schicht (11) eine wärmeleitende Schicht ist, die komprimiert werden kann, um sich zu verformen, sich speziell bezieht auf:
ein Verhältnis von Kompression und Verformung der ersten wärmeleitenden Schicht (11) unter der Wirkung eines ersten Drucks 5 % bis 90 % ist, wobei der erste Druck zwischen 0 N und 5000 N liegt.

3. Wärmeleitpad nach Anspruch 2, wobei, dass die zweite wärmeleitende Schicht (12) eine wärmeleitende Schicht ist, die nicht komprimiert werden kann, um sich zu verformen, sich speziell bezieht auf:
ein Verhältnis von Kompression und Verformung der zweiten wärmeleitenden Schicht (12) unter der Wirkung des ersten Drucks kleiner als oder gleich 5 % ist.

4. Wärmeleitpad nach einem der Ansprüche 1 bis 3, wobei
eine Dicke der ersten wärmeleitenden Schicht (11) 0,2 mm bis 5 mm ist und eine Dicke der zweiten wärmeleitenden Schicht (12) 0,1 mm bis 5 mm ist.

5. Wärmeleitpad nach einem der Ansprüche 1 bis 4, wobei eine Dicke der dritten wärmeleitenden Schicht kleiner als oder gleich 0,2 mm ist und die dritte wärmeleitende Schicht ein Prepreg ist oder die dritte wärmeleitende Schicht gelartig ist.

6. Wärmeleitpad nach Anspruch 1, wobei
der wärmeleitende Füllstoff (112) einen blattartigen wärmeleitenden Füllstoff umfasst; oder
der wärmeleitende Füllstoff (112) einen faserartigen wärmeleitenden Füllstoff umfasst; oder
der wärmeleitende Füllstoff (112) einen blattartigen wärmeleitenden Füllstoff und einen faserartigen wärmeleitenden Füllstoff umfasst.

7. Wärmeleitpad nach einem der Ansprüche 1 bis 6, wobei ein Material der zweiten wärmeleitenden Schicht (12) mindestens eines umfasst von: Metall oder Graphit.

8. Wärmeleitpad nach einem der Ansprüche 1 bis 7, wobei eine zweite Oberfläche der ersten wärmeleitenden Schicht (11) mit einem Kühlkörper (20) in Kontakt steht.

9. Elektronische Vorrichtung, die umfasst: das Wärmeleitpad nach einem der Ansprüche 1 bis 8 und eine wärmeemittierende Komponente (30), wobei eine Oberfläche des Wärmeleitpads mit einer Oberfläche der wärmeemittierenden Komponente (30) in Kontakt steht; und
das Wärmeleitpad konfiguriert ist, um eine Wärmeableitungsverarbeitung an Wärme durchzuführen, die durch die wärmeemittierende Komponente (30) erzeugt wird.

## Revendications

1. Feuille thermoconductrice configurée pour dissiper la chaleur d'un composant émettant de la chaleur (30), dans lequel
la feuille thermoconductrice comprend une première couche thermoconductrice (11) et une deuxième couche thermoconductrice (12), une seconde surface de la deuxième couche thermoconductrice (12) est en contact avec une première surface de la première couche thermoconductrice (11) ;
la première couche thermoconductrice (11) est une couche thermoconductrice qui peut être comprimée pour se déformer, une capacité de conduction thermique de la première couche thermoconductrice (11) dans une direction d'épaisseur de la première couche thermoconductrice (11) est supérieure à une capacité de conduction thermique de la première couche thermoconductrice (11) dans une direction plane de la première couche thermoconductrice (11), et la direction d'épaisseur de la première couche thermoconductrice (11) est perpendiculaire à la direction plane de la première couche thermoconductrice (11) ; et
la deuxième couche thermoconductrice (12) est une couche thermoconductrice qui ne peut pas être comprimée pour se déformer, une capacité de conduction de chaleur de la deuxième couche thermoconductrice (12) dans une direction plane de la deuxième couche thermoconductrice (12) est supérieure à une capacité de conduction de chaleur de la deuxième couche thermoconductrice (12) dans une direction d'épaisseur de la deuxième couche thermoconductrice (12), la capacité de conduction thermique de la deuxième couche thermoconductrice (12) dans la direction plane de la deuxième couche thermoconductrice (12) est supérieure ou égale à la capacité de conduction thermique de la première couche thermoconductrice (11) dans la direction de l'épaisseur de la première couche thermoconductrice (11), et la direction de l'épaisseur de la deuxième couche thermoconductrice (12) est perpendiculaire à la direction plane de la deuxième couche thermoconductrice (12) ;
la première couche thermoconductrice comprend une matrice organique et une charge thermoconductrice, et la charge thermoconductrice est orientée dans la première couche thermoconductrice dans le sens de l'épaisseur de la première couche thermoconductrice ;
dans laquelle la feuille thermoconductrice comprend en outre une troisième couche thermoconductrice, dans laquelle la troisième couche thermoconductrice est disposée entre le composant émetteur de chaleur (30) et la deuxième couche thermoconductrice (12), une première surface de la troisième couche thermoconductrice est en contact avec la surface du composant émetteur de chaleur (30), une seconde surface de la troisième couche thermoconductrice est en contact avec une première surface de la deuxième couche thermoconductrice (12), et la troisième couche thermoconductrice est configurée pour remplir un micro-vide sur la surface du composant émetteur de chaleur (30).

2. Feuille thermoconductrice selon la revendication 1, dans laquelle la première couche thermoconductrice (11) est une couche thermoconductrice qui peut être comprimée pour se déformer se réfère spécifiquement à :
un rapport de compression et de déformation de la première couche thermoconductrice (11) sous l'action de lapremière pression est compris entre 5 % et 90 %, dans laquelle la première pression est comprise entre 0 N et 5 000 N.

3. Feuille thermoconductrice selon la revendication 2, dans laquelle la deuxième couche thermoconductrice (12) est une couche thermoconductrice qui ne peut pas être comprimée pour se déformer se réfère spécifiquement à :
un rapport de compression et de déformation de la deuxième couche thermoconductrice (12) sous l'action de la première pression est inférieur ou égal à 5 %.

4. Feuille thermoconductrice selon l'une quelconque des revendications 1 à 3, dans laquelle
une épaisseur de la première couche thermoconductrice (11) est comprise entre 0,2 mm et 5 mm, et une épaisseur de la deuxième couche thermoconductrice (12) est comprise entre 0,1 mm et 5 mm.

5. Feuille thermoconductrice selon l'une quelconque des revendications 1 à 4, dans laquelle l'épaisseur de la troisième couche thermoconductrice est inférieure ou égale à 0,2 mm, et la troisième couche thermoconductrice est un pré-imprégné ou la troisième couche thermoconductrice est de type gel.

6. Feuille thermoconductrice selon la revendication 1, dans laquelle
la charge thermoconductrice (112) comprend une charge thermoconductrice de type feuille ; ou
la charge thermoconductrice (112) comprend une charge thermoconductrice de type fibre ; ou
la charge thermoconductrice (112) comprend une charge thermoconductrice de type feuille et une charge thermoconductrice de type fibre.

7. Feuille thermoconductrice selon l'une quelconque des revendications 1 à 6, dans laquelle un matériau de la deuxième couche thermoconductrice (12) comprend au moins l'un des matériaux suivants : métal ou graphite.

8. Feuille thermoconductrice selon l'une quelconque des revendications 1 à 7, dans lequel une seconde surface de la première couche thermoconductrice (11) est en contact avec un dissipateur thermique (20).

9. Dispositif électronique, comprenant : la feuille thermoconductrice selon l'une quelconque des revendications 1 à 8 et un composant émetteur de chaleur (30), dans lequel une surface de la feuille thermoconductrice est en contact avec une surface du composant émetteur de chaleur (30) ; et
la feuille thermoconductrice est configurée pour dissiper la chaleur générée par le composant émetteur de chaleur (30).
